# EUROPEAN PATENT APPLICATION

(11) **EP 4 844 980 A1**
(43) Date of publication of application: **25.11.2026**
(21) Application number: 26180314.2
(22) Date of filing: 21.05.2026
(51) Int. Cl.: H02J 9/06, G01R 31/40, H02J 7/80, H02J 9/00

(54) **UPS PARALLEL SYSTEM AND BATTERY MAINTENANCE DISCHARGE TEST METHOD THEREFOR**

(30) Priority: 23.05.2025 CN 202510679618
(71) Applicant: HUAWEI TECHNOLOGIES CO., LTD., Shenzhen 518129 (CN)
(72) Inventor: SHU, Zhou, Shenzhen 518129 (CN); LI, Junlin, Shenzhen 518129 (CN)
(74) Representative: Gill Jennings & Every LLP

(57) **Abstract**

This application provides a UPS parallel system and a battery maintenance discharge test method therefor. During a battery maintenance discharge test for the UPS parallel system, an unbalanced output power allocation strategy is used, so that a UPS under the battery maintenance discharge test provides a larger output power, thereby controlling high-power discharge of an energy storage apparatus connected to the UPS, to fully expose potential risks of a battery circuit and battery discharge performance, and improve reliability of the UPS parallel system. For the UPS parallel system including a UPS that includes a plurality of power conversion modules, when a battery test is performed on an energy storage apparatus connected to a single UPS, a power conversion module in a UPS that is not in the battery maintenance discharge test is in a sleep mode, so that the UPS that is in the battery maintenance discharge test can provide the larger output power.

## Description

### TECHNICAL FIELD

The present invention relates to the field of new energy technologies, and to a UPS parallel system and a battery maintenance discharge test method therefor.

### BACKGROUND

An uninterruptible power supply (UPS) system can continuously supply power to a load in place of a power grid during abnormalities (for example, power failures or undervoltage) of the power grid, to maintain normal operation of the load. Specifically, the UPS system mainly includes a UPS and a battery, and the UPS is separately connected to the power grid, the load, and the battery. The UPS can monitor an operating status of the power grid. When the power grid is normal, the UPS can supply power to the load by using electric energy provided by the power grid. When the power grid is abnormal, the UPS can control battery discharge and continue to supply power to the load by using electric energy provided by the battery. If the battery in the UPS system has not been discharged for a long time, reliability of a battery circuit and battery discharge performance are unknown, posing a risk to the UPS system. To ensure reliability of the UPS system, a battery maintenance discharge test plan is typically formulated.

Currently, with a load capacity of a data center increasing, a plurality of UPSs are generally connected in parallel to form a UPS parallel system to supply power to the load. After the plurality of UPSs are connected in parallel, the system usually adopts a current-sharing control strategy to evenly distribute an output power. As a result, during a battery maintenance discharge test for the UPS parallel system, a discharge power of the battery is low, and potential risks of the battery circuit and battery discharge performance cannot be fully exposed.

### SUMMARY

This application provides a UPS parallel system and a battery maintenance discharge test method therefor, to fully expose potential risks of a battery circuit and battery discharge performance during a battery maintenance discharge test for the UPS parallel system.

According to a first aspect, this application provides a UPS parallel system, including a plurality of UPSs, where rated capacities of the plurality of UPSs are generally the same. Each UPS includes an alternating current input end, a direct current input end, an alternating current output end, a power conversion module, and a controller. The alternating current input end of each UPS is configured to connect to a power grid, and an alternating current input to the alternating current input end of each UPS may come from a same power grid, or may come from different power grids. The direct current input end of each UPS is configured to connect to an energy storage apparatus, and alternating current output ends of the UPSs are connected in parallel and are configured to connect to a load. In some other embodiments of this application, the plurality of UPSs may further form a 2N power supply system, each power supply system includes a same quantity of UPSs, and alternating current output ends of the UPSs in each power supply system are connected in parallel and then connected to a load by using a same switch.

In this application, during a battery maintenance discharge test for the UPS parallel system, the plurality of UPSs are divided into a first UPS and a second UPS. The first UPS is a UPS on which a battery maintenance discharge test is currently performed, and the second UPS is a UPS on which no battery maintenance discharge test is currently performed. When a battery test is performed on an energy storage apparatus connected to the first UPS, a controller of the first UPS is configured to: control a power conversion module of the first UPS to perform, with a first output power, power conversion on electric energy input from a direct current input end of the first UPS, and output electric energy obtained through power conversion to an alternating current output end of the first UPS; and a controller of the second UPS is configured to: control a power conversion module of the second UPS to perform, with a second output power, power conversion on electric energy input from an alternating current input end of the second UPS, and output electric energy obtained through power conversion to an alternating current output end of the second UPS. In other words, when the battery test is performed on the energy storage apparatus connected to the first UPS, the first UPS continuously supplies power to the load by using the electric energy provided by the energy storage apparatus, and another UPS in the UPS parallel system continuously supplies power to the load by using electric energy provided by a power grid. In this application, during the battery maintenance discharge test for the UPS parallel system, an unbalanced output power allocation strategy is used. On the basis of ensuring that a sum of the first output power and the second output power is a total power of the load, the first output power of the first UPS is adjusted to be greater than the second output power of the second UPS, so that the first UPS under the battery maintenance discharge test provides a larger output power, thereby controlling high-power discharge of the energy storage apparatus connected to the first UPS, to fully expose potential risks of a battery circuit and battery discharge performance, and improve reliability of the UPS parallel system.

In this application, the controllers of the UPSs may communicate with each other by using a communication module, to determine a currently used control strategy. For example, when the battery test is performed on the energy storage apparatus connected to the first UPS, the controller of the first UPS may send an instruction to notify another UPS, so that the another UPS may reduce an output power according to a preset control strategy.

In some embodiments of this application, when the battery test is performed on the energy storage apparatus connected to the first UPS, the controller of the first UPS may control a discharge power of the energy storage apparatus connected to the first UPS to be greater than or equal to a preset discharge power. The preset discharge power may be, for example, 80% or 90% of a rated power, or even the preset discharge power may be set to a rated power. In this case, the energy storage apparatus connected to the first UPS under the battery maintenance discharge test discharges at a high power or even at full load, to fully expose potential risks of a battery circuit and battery discharge performance, improving reliability of the UPS parallel system.

In some embodiments of this application, more than two UPSs are generally disposed in the UPS parallel system, that is, when the battery test is performed on the energy storage apparatus connected to the first UPS, there are a plurality of second UPSs. An output power may be evenly allocated among the plurality of second UPSs by using a current-sharing control strategy. To be specific, the controller of each second UPS may control the power conversion module of each second UPS to perform, with the same second output power, power conversion on the electric energy input from the alternating current input end of the second UPS, to simplify control complexity. In some other embodiments of this application, the output power may alternatively be allocated among the plurality of second UPSs according to an unequal sharing control strategy.

In some other embodiments of this application, each UPS may include a plurality of power conversion modules connected in parallel. When the battery test is performed on the energy storage apparatus connected to the first UPS, the controller of the first UPS usually controls all power conversion modules to be in an operating state, to meet a requirement for high-power discharge of a battery. In addition, the controller of the first UPS may control each power conversion module in the first UPS to perform, with a same output power, power conversion on the electric energy input from the direct current input end of the first UPS, where a sum of output powers of the power conversion modules in the first UPS is equal to the first output power. When the battery test is performed on the energy storage apparatus connected to the first UPS, the controller of the second UPS may control at least one power conversion module in the second UPS to be in a sleep mode, to achieve an unbalanced output power allocation strategy between the first UPS and the second UPS, and ensure that the first output power of the first UPS is greater than the second output power of the second UPS. In this way, the first UPS under the battery maintenance discharge test provides a larger output power, thereby controlling high-power discharge of the energy storage apparatus connected to the first UPS, to fully expose potential risks of a battery circuit and battery discharge performance, and improve reliability of the UPS parallel system.

In some embodiments of this application, when the battery test is performed on the energy storage apparatus connected to the first UPS, and there are a plurality of second UPSs, to ensure that an output power is evenly allocated among the plurality of second UPSs by using a current-sharing control strategy, that is, the controller of each second UPS controls the power conversion module of each second UPS to perform, with the same second output power, power conversion on electric energy input from an alternating current input end of the second UPS, the controller of each second UPS may control a same quantity of power conversion modules in each second UPS to be in the sleep mode. In some other embodiments of this application, different quantities of power conversion modules in the plurality of second UPSs may alternatively be controlled to be in the sleep mode according to an unequal output power sharing control strategy. A quantity of power conversion modules in the sleep mode in each second UPS is determined based on an allocated output power.

In this application, a quantity of power conversion modules in the sleep mode in the second UPS may be determined based on a proportion of an output power allocated to the second UPS. A smaller proportion of the output power allocated to the second UPS indicates a larger quantity of power conversion modules in the sleep mode.

In some embodiments of this application, the quantity of power conversion modules in the sleep mode in the second UPS may be further dynamically adjusted based on a power change of the load. In the process in which the battery test is performed on the energy storage apparatus connected to the first UPS, if a power of the load increases, some power conversion modules may be quickly woken up to meet an output power requirement.

In some embodiments of this application, when the battery test is performed on the energy storage apparatus connected to the first UPS, the controller of the second UPS may further control a plurality of power conversion modules to be cyclically in the sleep mode, to balance a service life of each power conversion module.

According to a second aspect, this application provides a battery maintenance discharge test method for a UPS parallel system, including: when a battery test is performed on an energy storage apparatus connected to a first UPS, controlling a power conversion module of the first UPS to perform, with a first output power, power conversion on electric energy provided by the energy storage apparatus connected to the first UPS, and then outputting electric energy obtained through power conversion; and when the battery test is performed on the energy storage apparatus connected to the first UPS, controlling a second UPS in the UPS system to perform, with a second output power, power conversion on electric energy input from an alternating current input end of the second UPS, and then outputting electric energy obtained through power conversion. In other words, when the battery test is performed on the energy storage apparatus connected to the first UPS, the first UPS continuously supplies power to a load by using the electric energy provided by the energy storage apparatus, and another UPS in the UPS parallel system continuously supplies power to the load by using electric energy provided by a power grid. In this application, during the battery maintenance discharge test for the UPS parallel system, an unbalanced output power allocation strategy is used. On the basis of ensuring that a sum of the first output power and the second output power is a total power of the load, the first output power of the first UPS is adjusted to be greater than the second output power of the second UPS, so that the first UPS under the battery maintenance discharge test provides a larger output power, thereby controlling high-power discharge of the energy storage apparatus connected to the first UPS, to fully expose potential risks of a battery circuit and battery discharge performance, and improve reliability of the UPS parallel system.

In some embodiments of this application, when the battery test is performed on the energy storage apparatus connected to the first UPS, a discharge power of the energy storage apparatus connected to the first UPS may be controlled to be greater than or equal to a preset discharge power. The preset discharge power may be, for example, 80% or 90% of a rated power, or even the preset discharge power may be set to a rated power. In this case, the energy storage apparatus connected to the first UPS under the battery maintenance discharge test discharges at a high power or even at full load, to fully expose potential risks of a battery circuit and battery discharge performance, improving reliability of the UPS parallel system.

In some embodiments of this application, more than two UPSs are generally disposed in the UPS parallel system, that is, when the battery test is performed on the energy storage apparatus connected to the first UPS, there are a plurality of second UPSs. An output power may be evenly allocated among the plurality of second UPSs by using a current-sharing control strategy. To be specific, a power conversion module of each second UPS may be controlled to perform, with the same second output power, power conversion on the electric energy input from the alternating current input end of the second UPS, to simplify control complexity. In some other embodiments of this application, the output power may alternatively be allocated among the plurality of second UPSs according to an unequal sharing control strategy.

In some other embodiments of this application, each UPS may include a plurality of power conversion modules connected in parallel. When the battery test is performed on the energy storage apparatus connected to the first UPS, all power conversion modules of the first UPS are generally controlled to be in an operating state, to meet a requirement for high-power discharge of a battery. In addition, each power conversion module in the first UPS may be controlled to perform, with a same output power, power conversion on electric energy input from a direct current input end of the first UPS, where a sum of output powers of the power conversion modules in the first UPS is equal to the first output power. When the battery test is performed on the energy storage apparatus connected to the first UPS, at least one power conversion module in the second UPS may be controlled to be in a sleep mode, to achieve the unbalanced output power allocation strategy between the first UPS and the second UPS, and ensure that the first output power of the first UPS is greater than the second output power of the second UPS. In this way, the first UPS under the battery maintenance discharge test provides a larger output power, thereby controlling high-power discharge of the energy storage apparatus connected to the first UPS, to fully expose potential risks of a battery circuit and battery discharge performance, and improve reliability of the UPS parallel system.

In some embodiments of this application, when the battery test is performed on the energy storage apparatus connected to the first UPS, and there are a plurality of second UPSs, to ensure that an output power is evenly allocated among the plurality of second UPSs by using a current-sharing control strategy, that is, the power conversion module of each second UPS may be controlled to perform, with the same second output power, power conversion on the electric energy input from the alternating current input end of the second UPS, a same quantity of power conversion modules in each second UPS may be controlled to be in the sleep mode. In some other embodiments of this application, different quantities of power conversion modules in the plurality of second UPSs may alternatively be controlled to be in the sleep mode according to an unequal output power sharing control strategy. A quantity of power conversion modules in the sleep mode in each second UPS is determined based on an allocated output power.

In this application, a quantity of power conversion modules in the sleep mode in the second UPS may be determined based on a proportion of an output power allocated to the second UPS. A smaller proportion of the output power allocated to the second UPS indicates a larger quantity of power conversion modules in the sleep mode.

In some embodiments of this application, the quantity of power conversion modules in the sleep mode in the second UPS may be further dynamically adjusted based on a power change of the load. In the process in which the battery test is performed on the energy storage apparatus connected to the first UPS, if a power of the load increases, some power conversion modules may be quickly woken up to meet an output power requirement.

In some embodiments of this application, when the battery test is performed on the energy storage apparatus connected to the first UPS, a plurality of power conversion modules of the second UPS may be further controlled to be cyclically in the sleep mode, to balance a service life of each power conversion module.

### BRIEF DESCRIPTION OF DRAWINGS

FIG. 1 is a schematic of a circuit structure of a UPS system;
FIG. 2 is a diagram of an architecture of a UPS parallel system;
FIG. 3 is a diagram of another architecture of a UPS parallel system;
FIG. 4 is a schematic of a circuit in a UPS parallel system according to an embodiment of this application; and
FIG. 5 is a schematic of another circuit in a UPS parallel system according to an embodiment of this application.

### DESCRIPTION OF EMBODIMENTS

To make the objectives, technical solutions, and advantages of this application clearer, the following further describes this application in detail with reference to the accompanying drawings. However, example implementations may be implemented in a plurality of forms and should not be construed as being limited to the implementations described herein. On the contrary, these implementations are provided such that this application is more comprehensive and complete and fully conveys the concept of the example implementations to a person skilled in the art. Identical reference numerals in the accompanying drawings denote identical or similar structures. Therefore, repeated description thereof is omitted. Expressions of locations and directions in this application are described by using the accompanying drawings as an example. However, changes may also be made as required, and all the changes fall within the protection scope of this application. The accompanying drawings in this application are merely used to illustrate relative position relationships and do not represent an actual scale.

It should be noted that details are set forth in the following description for ease of fully understanding this application. However, this application can be implemented in a plurality of manners different from those described herein, and a person skilled in the art can perform similar promotion without departing from the connotation of this application. Therefore, this application is not limited to the following disclosed specific implementations. The following descriptions of this specification are example implementations of this application. However, the descriptions are intended to describe the general principle of this application, and are not intended to limit the scope of this application. The protection scope of this application shall be defined by the appended claims.

Before embodiments of this application are described, some terms used in embodiments of this application are first described as an example.

Data center 2N power supply architecture: The power supply architecture includes two power distribution units. Each power distribution unit can meet full power consumption demand of a load. The two power distribution units operate simultaneously, and each power distribution unit generally provides 50% of an output power. When one power distribution unit is faulty and stops running, the other power distribution unit supplies 100% electric energy to the load.

Battery maintenance discharge test: is a test performed to discharge a battery and verify reliability of a battery circuit and battery discharge performance. The battery maintenance discharge test is generally classified into a shallow discharge test and a capacity verification test.

Shallow discharge test: is to discharge a battery partially, and is a shallow discharge test method performed to verify reliability of a battery circuit and a short-term discharge capability of the battery, and a shallow discharge capacity is generally 20% to 30% of a battery capacity.

Capacity verification test: is to fully discharge a battery, and is a deep discharge test method for accurately obtaining discharge performance of the battery.

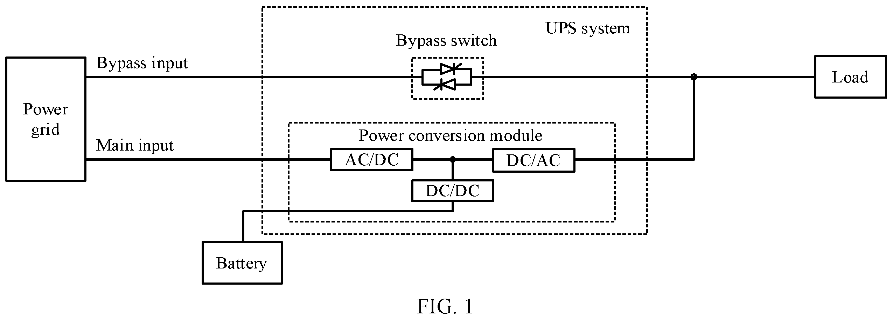

FIG. 1 is an example schematic of a circuit structure of a UPS system. Refer to FIG. 1. The UPS system is separately connected to a power grid, a load, and a battery. The UPS system mainly includes a power conversion module connected to a main input, and the power conversion module includes a rectifier (AC/DC), an inverter (DC/AC), and a charging and discharging circuit (DC/DC). When an input of the power grid is normal, the UPS system performs AC/DC and DC/AC conversion and voltage regulation on electric energy, to supply power to the load, supplied by the power grid, and simultaneously charges the battery through DC/DC. When the power grid is interrupted (or an accidental power outage occurs), the UPS system immediately performs DC/DC and DC/AC conversion and voltage regulation on direct-current electric energy of the battery, to supply power to the load. In some application scenarios, as a backup of a power supply link, the UPS system may further include a bypass switch connected to a bypass input. When a bypass input is normal, electric energy provided by the power grid may also be directly supplied to the load by the bypass input through the bypass switch, that is, the UPS system can operate in an economic control operation (ECO) mode.

The power grid may be an urban power grid, a photovoltaic power grid, a microgrid, a residential power grid, an industrial power grid, or the like. The power grid may continuously supply power to the UPS system. There are a plurality of possibilities of electric energy supplied by the power grid to the UPS system. For example, the electric energy may be alternating current or direct current, may be high-frequency alternating current or low-frequency alternating current, or may be high voltage or low voltage. The electric energy supplied by the power grid to the UPS system is mainly determined by a type of the power grid. This is not further limited in this embodiment of this application. The following description is based on an example in which the power grid supplies an alternating current (that is, alternating current input) to the UPS system.

When the power grid remains powered, the UPS system can use the electric energy provided by the power grid to power the load. Specifically, in a possible implementation, the power grid may directly forward, through the bypass input, the electric energy provided by the power grid to the load. For example, if the power grid inputs a 220 V, 50 Hz alternating current to the UPS system, the UPS system directly outputs the 220 V, 50 Hz alternating current to the load through the bypass input.

In another possible implementation, the UPS system may alternatively convert the electric energy supplied by the power grid, for example, in one or more of the following conversion manners: rectifier conversion, inverter conversion, boost conversion, and buck conversion, to output electric energy adapting to the load. For example, if the power grid inputs alternating-current electric energy into the UPS system and the load is a direct-current load, the UPS system may perform rectifier conversion on the alternating-current electric energy supplied by the power grid to convert the alternating-current electric energy into direct-current electric energy, and then supply the direct-current electric energy to the load. If a voltage of the direct-current energy obtained through rectifier conversion is high and the load is a low-voltage direct-current load, the UPS system may further perform buck conversion on the direct-current electric energy to obtain low-voltage direct-current electric energy, and then supply the low-voltage direct-current electric energy to the load.

When the power grid remains powered, the UPS system can continuously monitor a power supply status of the power grid. When a power failure occurs on the power grid, the UPS system can continue to supply power to load by using electric energy provided by the battery. It should be noted that, that "a power failure occurs on the power grid" should be understood as a case in which the UPS system cannot receive normal electric energy from the power grid. For example, the UPS system does not receive electric energy from the power grid, or a voltage sag occurs in electric energy supplied by the power grid (a voltage input by the power grid is 15% to 20% lower than a nominal voltage for seconds), or a surge occurs in electric energy supplied by the power grid (a voltage input by the power grid is more than 10% higher than a nominal voltage for seconds), or severe interference exists in electric energy supplied by the power grid. All these abnormalities may be understood as that "a power failure occurs on the power grid".

When continuing to supply power to the load by using the electric energy supplied by the battery, the UPS system may directly forward, to the load, the electric energy supplied by the battery; or may convert the electric energy supplied by the battery, for example, in one or more of the following conversion manners: inverter conversion, boost conversion, and buck conversion, to output electric energy adapting to the load. For example, the load is an alternating-current load, and the UPS system may perform inverter conversion on direct-current electric energy supplied by the battery, to obtain alternating-current electric energy, and supply the alternating-current electric energy to the load.

The battery may include a plurality of battery packs or a plurality of cells. The battery supplies power to the UPS system, which may be understood as that the plurality of battery packs or the plurality of cells output electric energy to the UPS system in parallel. Usually, a battery in the battery may be a storage battery. When the power grid remains powered, the UPS system can use the electric energy provided by the power grid to charge the battery. When a power failure occurs on the power grid, the battery may release stored electric energy to the UPS system, ensuring uninterrupted power supply of the UPS system to load.

When powered by the battery, the UPS system can continuously monitor the power supply status of the power grid. After power supplying of the power grid is restored, the UPS system can switch to being powered by the power grid and continue to supply electric energy supplied by the power grid to the load.

The load operates by using the electric energy provided by the UPS system. It should be understood that there may be different implementations of the load based on variations of application scenarios. For example, the load may be a household appliance, for example, a refrigerator, a washing machine, an air conditioner, or an electric lamp. In this case, the power grid may be a residential power grid, and the UPS system may uninterruptedly supply power to the household appliance. For another example, the load may be a community. In this case, the power grid may be an urban power grid, and the UPS system may uninterruptedly supply power to all residents in the community. For still another example, the load may be a data center. In this case, the power grid may be an industrial power grid, and the UPS system may uninterruptedly supply power to the data center. There are a plurality of possibilities of application scenarios of the UPS system, and the application scenarios are not described one by one.

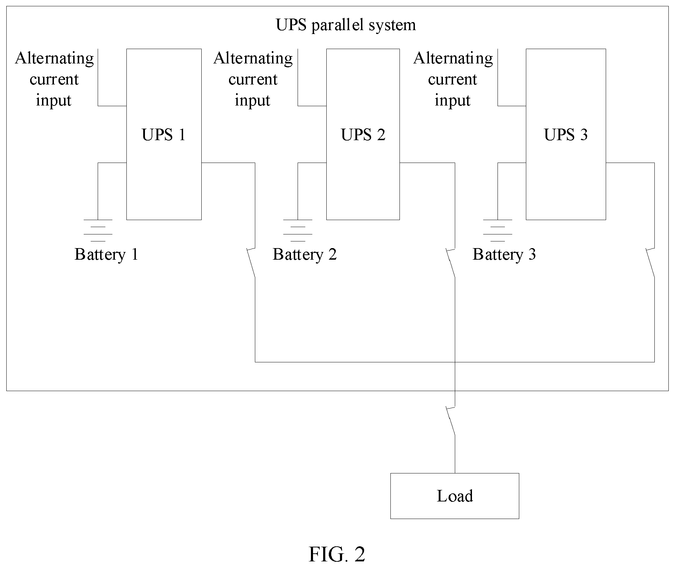

FIG. 2 is an example diagram of an architecture of a UPS parallel system. Refer to FIG. 2. With a load capacity of a data center increasing, a plurality of UPSs are generally connected in parallel to form a UPS parallel system to supply power to a load in a data center scenario. The UPS parallel system usually adopts, based on a model capacity, a current-sharing control strategy to evenly distribute an output power. That is, if rated capacities of all UPSs in the UPS parallel system are the same, the UPSs share a current in a ratio of 1:1:1. For example, if the output power is 800 kW and the UPS parallel system includes three UPSs, each UPS has a rated capacity of 600 kVA, and each UPS provides an output power of 266.7 kW.

If a battery in the UPS parallel system has not been discharged for a long time, reliability of a battery circuit and battery discharge performance are unknown, posing a risk to the UPS parallel system. To ensure reliability of the UPS parallel system, a battery maintenance discharge test plan is usually made. The battery maintenance discharge test usually includes a capacity verification test or a shallow discharge test. During the battery maintenance discharge test for the UPS parallel system, the test is performed on the UPSs in rotation as planned. A battery test is performed on an energy storage apparatus connected to the first UPS, and after the test is completed, the energy storage apparatus connected to the first UPS is fully charged. Next, an energy storage apparatus connected to the second UPS is started for the battery test, and after the test is completed, the energy storage apparatus connected to the second UPS is fully charged. Then, an energy storage apparatus connected to the third UPS is started for the battery test, and after the test is completed, the energy storage apparatus connected to the third UPS is fully charged. By analogy, the battery maintenance discharge test is completed for all the UPSs.

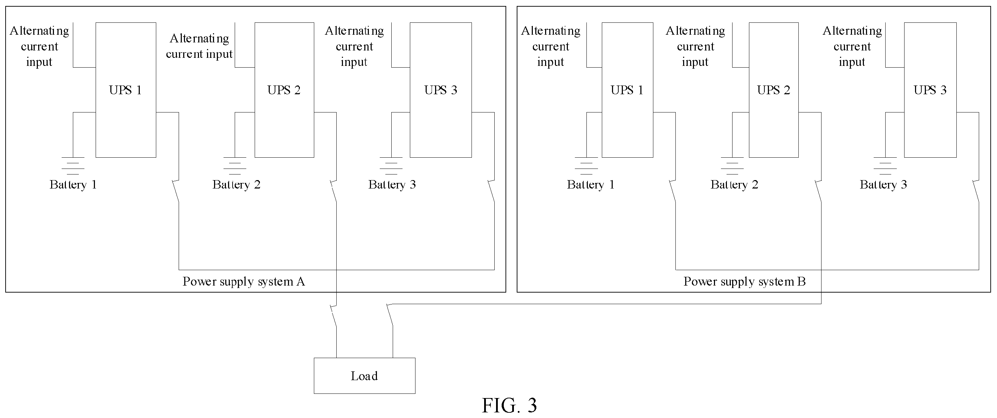

FIG. 3 is an example diagram of another architecture of a UPS parallel system. To ensure reliability, a UPS parallel system in a data center usually uses a 2N power supply architecture or an N+1 redundant power supply architecture. Refer to FIG. 3. The 2N power supply architecture includes two power supply systems (A and B). Each power supply system can meet full power consumption demand of a load. When the two power supply systems operate simultaneously, each power supply system usually provides 50% of an output power. For example, if a power of the load is 1600 kW, the power supply systems A and B each provide an output power of 800 kW. If each power supply system includes three UPSs and a rated capacity of each UPS is 600 kVA, each UPS provides an output power of 266.7 kW when the two power supply systems operate simultaneously. In this way, the output power of each UPS is low under a normal working condition, and is usually less than 50% of the rated capacity. As a result, during a battery maintenance discharge test for the UPS parallel system, a discharge power of a battery is also low, and potential risks of a battery circuit and battery discharge performance cannot be fully exposed. Especially in an abnormal working condition, for example, when one of the two power supply systems in the 2N power supply architecture is faulty, each UPS needs to provide twice the output power in the normal working condition. Therefore, the potential risk that is not exposed during the battery maintenance discharge test may reduce reliability of the UPS parallel system.

In view of this, this application provides a UPS parallel system and a battery maintenance discharge test method therefor. During the battery maintenance discharge test for the UPS parallel system, an unbalanced output power allocation strategy is used, so that a UPS under the battery maintenance discharge test provides a larger output power, thereby controlling high-power discharge of a battery, to fully expose potential risks of a battery circuit and battery discharge performance.

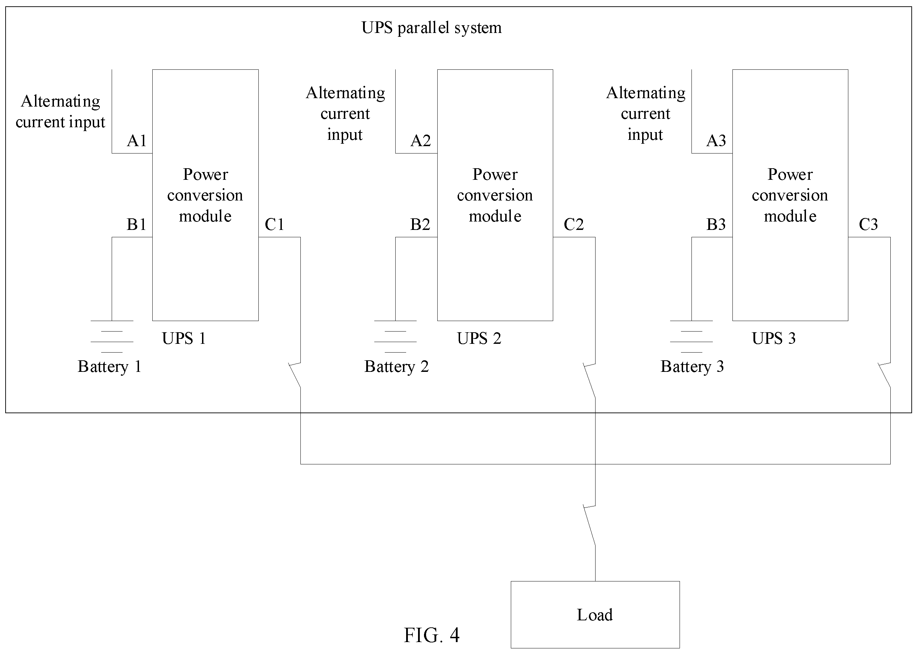

FIG. 4 is an example schematic of a circuit in a UPS parallel system according to an embodiment of this application. Refer to FIG. 4. The UPS parallel system provided in this application mainly includes a plurality of UPSs, and rated capacities of the plurality of UPSs are generally the same. In FIG. 4, an example in which the UPS parallel system includes three UPSs is used for description. Each UPS includes an alternating current input end Al (A2 or A3), a direct current input end B1 (B2 or B3), an alternating current output end C1 (C2 or C3), a power conversion module, and a controller (not shown in the figure). The alternating current input end A1 (A2 or A3) of each UPS is configured to connect to a power grid, and an alternating current input to the alternating current input end Al (A2 or A3) of each UPS may come from a same power grid, or may come from different power grids. The direct current input end B1 (B2 or B3) of each UPS is configured to connect to a separate energy storage apparatus, that is, a battery, and alternating current output ends C1 (C2 or C3) of the UPSs are connected in parallel and are configured to connect to a load. In some other embodiments of this application, the plurality of UPSs may further form a 2N power supply system, each power supply system includes a same quantity of UPSs, and alternating current output ends of the UPSs in each power supply system are connected in parallel and then connected to a load by using a same switch.

In this application, during a battery maintenance discharge test for the UPS parallel system, the plurality of UPSs are divided into a first UPS and a second UPS. The first UPS is a UPS on which a battery maintenance discharge test is currently performed, and the second UPS is a UPS on which no battery maintenance discharge test is currently performed. When a battery test is performed on an energy storage apparatus connected to the first UPS, a controller of the first UPS is configured to: control a power conversion module of the first UPS to perform, with a first output power, power conversion on electric energy input from a direct current input end of the first UPS, and output electric energy obtained through power conversion to an alternating current output end of the first UPS; and a controller of the second UPS is configured to: control a power conversion module of the second UPS to perform, with a second output power, power conversion on electric energy input from an alternating current input end of the second UPS, and output electric energy obtained through power conversion to an alternating current output end of the second UPS. In other words, when the battery test is performed on the energy storage apparatus connected to the first UPS, the first UPS continuously supplies power to the load by using the electric energy provided by the energy storage apparatus, and another UPS in the UPS parallel system continuously supplies power to the load by using electric energy provided by a power grid. In this application, during the battery maintenance discharge test for the UPS parallel system, an unbalanced output power allocation strategy is used. On the basis of ensuring that a sum of the first output power and the second output power is a total power of the load, the first output power of the first UPS is adjusted to be greater than the second output power of the second UPS, so that the first UPS under the battery maintenance discharge test provides a larger output power, thereby controlling high-power discharge of the energy storage apparatus connected to the first UPS, to fully expose potential risks of a battery circuit and battery discharge performance, and improve reliability of the UPS parallel system.

In this application, the controllers of the UPSs may communicate with each other by using a communication module, to determine a currently used control strategy. For example, when the battery test is performed on the energy storage apparatus connected to the first UPS, the controller of the first UPS may send an instruction to notify another UPS, so that the another UPS may reduce an output power according to a preset control strategy.

In some embodiments of this application, when the battery test is performed on the energy storage apparatus connected to the first UPS, the controller of the first UPS may control a discharge power of the energy storage apparatus connected to the first UPS to be greater than or equal to a preset discharge power. The preset discharge power may be, for example, 80% or 90% of a rated power, or even the preset discharge power may be set to a rated power. In this case, the energy storage apparatus connected to the first UPS under the battery maintenance discharge test discharges at a high power or even at full load, to fully expose potential risks of a battery circuit and battery discharge performance, improving reliability of the UPS parallel system.

In some embodiments of this application, more than two UPSs are generally disposed in the UPS parallel system, that is, when a battery test is performed on the energy storage apparatus connected to the first UPS, there are a plurality of second UPSs. When the battery test is performed on the energy storage apparatus connected to the first UPS, an output power may be evenly allocated among the plurality of second UPSs by using a current-sharing control strategy. To be specific, the controller of each second UPS may control the power conversion module of each second UPS to perform, with the same second output power, power conversion on the electric energy input from the alternating current input end of the second UPS, to simplify control complexity. In some other embodiments of this application, the output power may alternatively be allocated among the plurality of second UPSs according to an unequal sharing control strategy. This is not limited herein.

For example, a power of the load in FIG. 4 is 800 kW. If the UPS parallel system includes three UPSs, a rated capacity of each UPS is 600 kVA. During the battery maintenance discharge test for the UPS parallel system, the test is performed on the UPSs in rotation as planned and the unbalanced output power allocation strategy is used. A detailed implementation process is as follows: When a battery test is performed on the energy storage apparatus connected to the first UPS, an output power may be allocated in a ratio of 6:1:1, so that the first UPS provides an output power of 600 kW, and the second UPS and third UPS each provide an output power of 100 kW. After the test is completed, the energy storage apparatus connected to the first UPS is fully charged, and then an energy storage apparatus connected to the second UPS is started for the battery test. When the battery test is performed on the energy storage apparatus connected to the second UPS, the output power may be allocated in a ratio of 1:6:1, so that the second UPS provides an output power of 600 kW, and the first UPS and the third UPS each provide an output power of 100 kW. After the test is completed, the energy storage apparatus connected to the second UPS is fully charged, and finally an energy storage apparatus connected to the third UPS is started for the battery test. When the battery test is performed on the energy storage apparatus connected to the third UPS, the output power may be allocated in a ratio of 1:1:6, so that the third UPS provides an output power of 600 kW, and the first UPS and the second UPS each provide an output power of 100 kW. After the test is completed, the energy storage apparatus connected to the third UPS is fully charged. In this case, the battery maintenance discharge test is complete for all the UPSs.

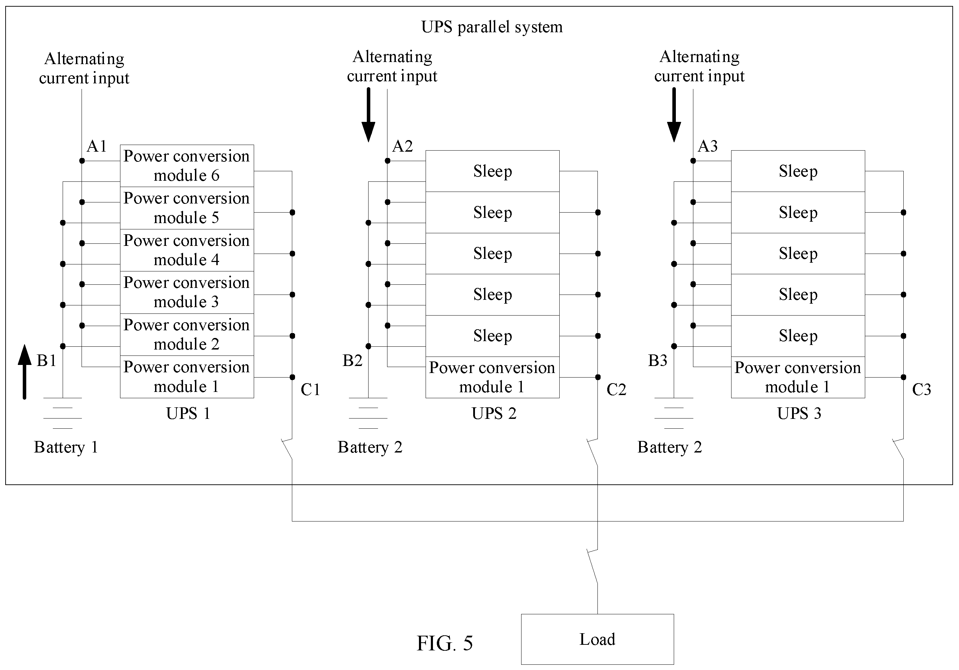

FIG. 5 is an example schematic of another circuit in a UPS parallel system according to an embodiment of this application. Refer to FIG. 5. In some other embodiments of this application, each UPS may include a plurality of power conversion modules connected in parallel. In FIG. 5, an example in which each UPS includes six power conversion modules is used for description. When a battery test is performed on an energy storage apparatus connected to a first UPS, a controller of the first UPS usually controls all power conversion modules to be in an operating state, to meet a requirement for high-power discharge of a battery. In addition, the controller of the first UPS may control each power conversion module in the first UPS to perform, with a same output power, power conversion on electric energy input from a direct current input end of the first UPS, where a sum of output powers of the power conversion modules in the first UPS is equal to the first output power. When the battery test is performed on the energy storage apparatus connected to the first UPS, a controller of a second UPS may control at least one power conversion module in the second UPS to be in a sleep mode, to achieve an unbalanced output power allocation strategy between the first UPS and the second UPS, and ensure that the first output power of the first UPS is greater than a second output power of the second UPS. In this way, the first UPS under a battery maintenance discharge test provides a larger output power, thereby controlling high-power discharge of the energy storage apparatus connected to the first UPS, to fully expose potential risks of a battery circuit and battery discharge performance, and improve reliability of the UPS parallel system.

In some embodiments of this application, when the battery test is performed on the energy storage apparatus connected to the first UPS, and there are a plurality of second UPSs, to ensure that an output power is evenly allocated among the plurality of second UPSs by using a current-sharing control strategy, that is, the controller of each second UPS controls the power conversion module of each second UPS to perform, with the same second output power, power conversion on electric energy input from an alternating current input end of the second UPS, the controller of each second UPS may control a same quantity of power conversion modules in each second UPS to be in the sleep mode. In some other embodiments of this application, different quantities of power conversion modules in the plurality of second UPSs may alternatively be controlled to be in the sleep mode according to an unequal output power sharing control strategy. A quantity of power conversion modules in the sleep mode in each second UPS is determined based on an allocated output power. This is not limited herein.

In this application, a quantity of power conversion modules in the sleep mode in the second UPS may be determined based on a proportion of an output power allocated to the second UPS. A smaller proportion of the output power allocated to the second UPS indicates a larger quantity of power conversion modules in the sleep mode.

In some embodiments of this application, the quantity of power conversion modules in the sleep mode in the second UPS may be further dynamically adjusted based on a power change of a load. In the process in which the battery test is performed on the energy storage apparatus connected to the first UPS, if a power of the load increases, some power conversion modules may be quickly woken up to meet an output power requirement.

In some embodiments of this application, when the battery test is performed on the energy storage apparatus connected to the first UPS, the controller of the second UPS may further control a plurality of power conversion modules to be cyclically in the sleep mode, to balance a service life of each power conversion module.

For example, the power of the load in FIG. 5 is 800 kW. If the UPS parallel system includes three UPSs, a rated capacity of each UPS is 600 kVA, and each UPS includes six power conversion modules. During the battery maintenance discharge test for the UPS parallel system, the test is performed on the UPSs in rotation as planned and the unbalanced output power allocation strategy is used. A detailed implementation process is as follows: When a battery test is performed on the energy storage apparatus connected to the first UPS, an output power may be allocated in a ratio of 6:1:1, all power conversion modules in the first UPS are controlled to be in an operating state, and five power conversion modules in each of the second UPS and the third UPS are controlled to be in the sleep mode and one power conversion module in each of the second UPS and the third UPS is in the operating state, so that the first UPS provides an output power of 600 kW, and the second UPS and the third UPS each provide an output power of 100 kW. After the test is completed, the energy storage apparatus connected to the first UPS is fully charged, and then an energy storage apparatus connected to the second UPS is started for the battery test. When the battery test is performed on the energy storage apparatus connected to the second UPS, the output power may be allocated in a ratio of 1:6:1, all power conversion modules in the second UPS are controlled to be in the operating state, and five power conversion modules in each of the first UPS and the third UPS are controlled to be in the sleep mode and one power conversion module in each of the first UPS and the third UPS is in the operating state, so that the second UPS provides an output power of 600 kW, and the first UPS and the third UPS each provide an output power of 100 kW. After the test is completed, the energy storage apparatus connected to the second UPS is fully charged, and finally an energy storage apparatus connected to the third UPS is started for the battery test. When the battery test is performed on the energy storage apparatus connected to the third UPS, the output power may be allocated in a ratio of 1:1:6, all power conversion modules in the third UPS are controlled to be in the operating state, and five power conversion modules in each of the first UPS and the second UPS are controlled to be in the sleep mode and one power conversion module in each of the first UPS and the second UPS is in the operating state, so that the third UPS provides an output power of 600 kW, and the first UPS and the second UPS each provide an output power of 100 kW. After the test is completed, the energy storage apparatus connected to the third UPS is fully charged. In this case, the battery maintenance discharge test is complete for all the UPSs.

Based on a same inventive concept, an embodiment of this application further provides a battery maintenance discharge test method for a UPS parallel system, including the following steps: When a battery test is performed on an energy storage apparatus connected to a first UPS, a power conversion module of the first UPS is controlled to perform, with a first output power, power conversion on electric energy provided by the energy storage apparatus connected to the first UPS, and then electric energy obtained through power conversion is output; and when the battery test is performed on the energy storage apparatus connected to the first UPS, a second UPS in the UPS system is controlled to perform, with a second output power, power conversion on electric energy input from an alternating current input end of the second UPS, and then electric energy obtained through power conversion is output. In other words, when the battery test is performed on the energy storage apparatus connected to the first UPS, the first UPS continuously supplies power to a load by using the electric energy provided by the energy storage apparatus, and another UPS in the UPS parallel system continuously supplies power to the load by using electric energy provided by a power grid. In this application, during a battery maintenance discharge test for the UPS parallel system, an unbalanced output power allocation strategy is used. On the basis of ensuring that a sum of the first output power and the second output power is a total power of the load, the first output power of the first UPS is adjusted to be greater than the second output power of the second UPS, so that the first UPS under the battery maintenance discharge test provides a larger output power, thereby controlling high-power discharge of the energy storage apparatus connected to the first UPS, to fully expose potential risks of a battery circuit and battery discharge performance, and improve reliability of the UPS parallel system.

In some embodiments of this application, when the battery test is performed on the energy storage apparatus connected to the first UPS, a discharge power of the energy storage apparatus connected to the first UPS may be controlled to be greater than or equal to a preset discharge power. The preset discharge power may be, for example, 80% or 90% of a rated power, or even the preset discharge power may be set to a rated power. In this case, the energy storage apparatus connected to the first UPS under the battery maintenance discharge test discharges at a high power or even at full load, to fully expose potential risks of a battery circuit and battery discharge performance, improving reliability of the UPS parallel system.

In some embodiments of this application, more than two UPSs are generally disposed in the UPS parallel system, that is, when the battery test is performed on the energy storage apparatus connected to the first UPS, there are a plurality of second UPSs. An output power may be evenly allocated among the plurality of second UPSs by using a current-sharing control strategy. To be specific, a power conversion module of each second UPS may be controlled to perform, with the same second output power, power conversion on the electric energy input from the alternating current input end of the second UPS, to simplify control complexity. In some other embodiments of this application, the output power may alternatively be allocated among the plurality of second UPSs according to an unequal sharing control strategy. This is not limited herein.

In some other embodiments of this application, each UPS may include a plurality of power conversion modules connected in parallel. When the battery test is performed on the energy storage apparatus connected to the first UPS, all power conversion modules of the first UPS are generally controlled to be in an operating state, to meet a requirement for high-power discharge of a battery. In addition, each power conversion module in the first UPS may be controlled to perform, with a same output power, power conversion on electric energy input from a direct current input end of the first UPS, where a sum of output powers of the power conversion modules in the first UPS is equal to the first output power. When the battery test is performed on the energy storage apparatus connected to the first UPS, at least one power conversion module in the second UPS may be controlled to be in a sleep mode, to achieve the unbalanced output power allocation strategy between the first UPS and the second UPS, and ensure that the first output power of the first UPS is greater than the second output power of the second UPS. In this way, the first UPS under the battery maintenance discharge test provides a larger output power, thereby controlling high-power discharge of the energy storage apparatus connected to the first UPS, to fully expose potential risks of a battery circuit and battery discharge performance, and improve reliability of the UPS parallel system.

In some embodiments of this application, when the battery test is performed on the energy storage apparatus connected to the first UPS, and there are a plurality of second UPSs, to ensure that an output power is evenly allocated among the plurality of second UPSs by using a current-sharing control strategy, that is, the power conversion module of each second UPS may be controlled to perform, with the same second output power, power conversion on the electric energy input from the alternating current input end of the second UPS, a same quantity of power conversion modules in each second UPS may be controlled to be in the sleep mode. In some other embodiments of this application, different quantities of power conversion modules in the plurality of second UPSs may alternatively be controlled to be in the sleep mode according to an unequal output power sharing control strategy. A quantity of power conversion modules in the sleep mode in each second UPS is determined based on an allocated output power. This is not limited herein.

In this application, a quantity of power conversion modules in the sleep mode in the second UPS may be determined based on a proportion of an output power allocated to the second UPS. A smaller proportion of the output power allocated to the second UPS indicates a larger quantity of power conversion modules in the sleep mode.

In some embodiments of this application, the quantity of power conversion modules in the sleep mode in the second UPS may be further dynamically adjusted based on a power change of the load. In the process in which the battery test is performed on the energy storage apparatus connected to the first UPS, if a power of the load increases, some power conversion modules may be quickly woken up to meet an output power requirement.

In some embodiments of this application, when the battery test is performed on the energy storage apparatus connected to the first UPS, a plurality of power conversion modules of the second UPS may be further controlled to be cyclically in the sleep mode, to balance a service life of each power conversion module.

According to the UPS parallel system and the battery maintenance discharge test method therefor provided in this application, during a battery maintenance discharge test for the UPS parallel system, an unbalanced output power allocation strategy is used, so that a UPS under the battery maintenance discharge test provides a larger output power, thereby controlling high-power discharge of an energy storage apparatus, to fully expose potential risks of a battery circuit and battery discharge performance, and improve reliability of the UPS parallel system.

It is clearly that, a person skilled in the art can make various modifications and variations to the present invention without departing from the scope of the present invention. The present invention is intended to cover these modifications and variations provided that they fall within the scope of protection defined by the claims of the present invention and their equivalent technologies.

## Claims

1. An uninterruptible power supply, UPS, parallel system, comprising a plurality of UPSs, wherein each UPS comprises: an alternating current input end, a direct current input end, an alternating current output end, a power conversion module, and a controller, the direct current input end is configured to connect to an energy storage apparatus, the power conversion module is configured to: perform power conversion on electric energy input from the alternating current input end and then transmit electric energy obtained through power conversion to the alternating current output end, and is further configured to: perform power conversion on electric energy input from the direct current input end and then transmit electric energy obtained through power conversion to the alternating current output end, and alternating current output ends of the plurality of UPSs are all configured to connect to a load;
the plurality of UPSs comprise a first UPS and a second UPS;
the controller of the first UPS is configured to: when a battery test is performed on the energy storage apparatus connected to the first UPS, control the power conversion module of the first UPS to perform, with a first output power, power conversion on electric energy input from the direct current input end of the first UPS, and output electric energy obtained through power conversion to the alternating current output end of the first UPS; and
the controller of the second UPS is configured to: when the battery test is performed on the energy storage apparatus connected to the first UPS, control the power conversion module of the second UPS to perform, with a second output power, power conversion on electric energy input from the alternating current input end of the second UPS, and output electric energy obtained through power conversion to the alternating current output end of the second UPS, wherein
the first output power is greater than the second output power.

2. The UPS parallel system according to claim 1, wherein the controller of the first UPS is configured to: when the battery test is performed on the energy storage apparatus connected to the first UPS, control a discharge power of the energy storage apparatus connected to the first UPS to be greater than or equal to a preset discharge power.

3. The UPS parallel system according to claim 1 or 2, wherein there are a plurality of second UPSs, and the controller of each second UPS is configured to: when the battery test is performed on the energy storage apparatus connected to the first UPS, control the power conversion module of each second UPS to perform, with the same second output power, power conversion on the electric energy input from the alternating current input end of the second UPS.

4. The UPS parallel system according to any one of claims 1 to 3, wherein each UPS comprises a plurality of power conversion modules connected in parallel; and
the controller of the first UPS is configured to: when the battery test is performed on the energy storage apparatus connected to the first UPS, control each power conversion module in the first UPS to perform, with a same output power, power conversion on the electric energy input from the direct current input end of the first UPS, wherein a sum of output powers of the power conversion modules in the first UPS is equal to the first output power.

5. The UPS parallel system according to any one of claims 1 to 4, wherein each UPS comprises a plurality of power conversion modules connected in parallel; and
the controller of the second UPS is configured to: when the battery test is performed on the energy storage apparatus connected to the first UPS, control at least one power conversion module in the second UPS to be in a sleep mode.

6. The UPS parallel system according to claim 5, wherein there are the plurality of second UPSs, and the controller of each second UPS is configured to: when the battery test is performed on the energy storage apparatus connected to the first UPS, control a same quantity of power conversion modules in each second UPS to be in the sleep mode.

7. A battery maintenance discharge test method for a UPS parallel system, comprising:
when a battery test is performed on an energy storage apparatus connected to a first UPS in the UPS system, controlling the first UPS to perform, with a first output power, power conversion on electric energy provided by the energy storage apparatus connected to the first UPS, and then outputting electric energy obtained through power conversion; and
when the battery test is performed on the energy storage apparatus connected to the first UPS, controlling a second UPS in the UPS system to perform, with a second output power, power conversion on electric energy input from an alternating current input end of the second UPS, and then outputting electric energy obtained through power conversion, wherein
the first output power is greater than the second output power.

8. The battery maintenance discharge test method according to claim 7, further comprising:
when the battery test is performed on the energy storage apparatus connected to the first UPS, controlling a discharge power of the energy storage apparatus connected to the first UPS to be greater than or equal to a preset discharge power.

9. The battery maintenance discharge test method according to claim 7 or 8, wherein there are a plurality of second UPSs, and the method further comprises:
when the battery test is performed on the energy storage apparatus connected to the first UPS, controlling a power conversion module of each second UPS to perform, with the same second output power, power conversion on the electric energy input from the alternating current input end of the second UPS.

10. The battery maintenance discharge test method according to any one of claims 7 to 9, wherein each UPS comprises a plurality of power conversion modules connected in parallel, and the method further comprises:
when the battery test is performed on the energy storage apparatus connected to the first UPS, controlling each power conversion module in the first UPS to perform, with a same output power, power conversion on electric energy input from a direct current input end of the first UPS, wherein a sum of output powers of the power conversion modules in the first UPS is equal to the first output power.

11. The battery maintenance discharge test method according to any one of claims 7 to 10, wherein each UPS comprises the plurality of power conversion modules connected in parallel, and the method further comprises:
when the battery test is performed on the energy storage apparatus connected to the first UPS, controlling at least one power conversion module in the second UPS to be in a sleep mode.

12. The battery maintenance discharge test method according to claim 11, wherein there are the plurality of second UPSs, and the method further comprises:
when the battery test is performed on the energy storage apparatus connected to the first UPS, controlling a same quantity of power conversion modules in each second UPS to be in the sleep mode.
